# EUROPÄISCHE PATENTSCHRIFT

(11) **EP 2 547 618 B1**
(45) Veröffentlichungstag und Bekanntmachung des Hinweises auf die Patenterteilung: **19.04.2017**
(21) Anmeldenummer: 11700456.4
(22) Anmeldetag: 21.01.2011
(51) Int. Cl.: B81C 3/00, B01L 3/00

(54) **VERFAHREN ZUR HERSTELLUNG EINER MIKROFLUIDISCHEN VORRICHTUNG**
METHOD FOR PRODUCING A MICROFLUIDIC DEVICE
PROCÉDÉ POUR LA RÉALISATION D'UN DISPOSITIF MICROFLUIDIQUE

(30) Priorität: 18.03.2010 DE 102010002991
(43) Veröffentlichungstag der Anmeldung: 23.01.2013
(73) Patentinhaber: Robert Bosch GmbH, 70442 Stuttgart (DE)
(72) Erfinder: SCHMIDT, Manuela, 73728 Esslingen (DE)
(86) Internationale Anmeldenummer: PCT/EP2011/050811
(87) Internationale Veröffentlichungsnummer: WO 2011/113630

(56) Entgegenhaltungen:
- DE-A1-102008 002 336
- US-A1- 2005 277 882
- US-A1- 2007 144 599
- US-B1- 6 620 478

## Beschreibung

Die vorliegende Erfindung betrifft ein Verfahren zur Herstellung einer mikrofluidischen Vorrichtung sowie mikrofluidische Vorrichtungen.

### Stand der Technik

Seit einigen Jahren hat sich das Laserschweißen als attraktive Fügetechnik für mikrofluidische Vorrichtungen aus thermoplastischen Kunststoffen erwiesen.

Dabei wird beispielsweise ein thermoplastisches Kunststoffbauteil, welches eine als Mikrokanal fungierende Vertiefung aufweist, mit einem Laserabsorber versetzt und durch Einwirken eines Laserstrahls mit einem anderen thermoplastischen Kunststoffbauteil verschweißt. Aus Justagegründen ist es jedoch nicht möglich, die Schweißnaht exakt bündig an der Vertiefungsöffnung entlang zu führen. Zudem hin kann das Volumen der Vertiefung verändert werden, wenn die Schweißnaht direkt entlang der Vertiefungsöffnung verläuft.

Die Druckschrift US 2004/0053237 A1 beschreibt die Herstellung einer mikrofluidischen Vorrichtung durch Anordnen einer Maskenschicht, welche Durchbrüche zum Ausbilden von Mikrokanälen aufweist, zwischen zwei Substraten und verbinden der Anordnung mittels Laserschweißens, wobei die Schweißnaht beabstandet zu den Mikrokanälen ausgebildet wird.

Eine durch ein herkömmliches Verfahren beabstandet zu den mikrofluidischen Räumen ausgebildete Schweißnaht kann jedoch dazu führen, dass sich zwischen den Substraten und gegebenenfalls der Maskenschicht im Bereich zwischen der Schweißnaht und den Mikrokanälen Kapillaren ausbilden. Eine Kapillarbildung entlang eines Mikrokanals ist für viele mikrofluidische Anwendungen jedoch problematisch.

Aus den Dokumenten US 2005/0277882 A1 und US 2007/0144599 A1 sind ein Verfahren und eine sich daraus ergebende Vorrichtung bekannt, welches das Anordnen von Elastomeren zwischen zwei Substraten, wobei mindestens eines der Substrate eine Vertiefung aufweist, sowie das Verschweißen der Substrate unter Beaufschlagung eines Pressdrucks auf die Substrate umfasst. Aus der DE 10 2008 002 336 A1 ist ebenfalls ein solches Verfahren mit korrespondierender Vorrichtung bekannt, wobei das dazwischen angeordnete Substrat als thermoplastische Elastomerfolie ausgebildet sein kann.

### Offenbarung der Erfindung

Gegenstand der vorliegenden Erfindung ist ein Verfahren zur Herstellung einer mikrofluidischen Vorrichtung, insbesondere eines mikrofluidischen Chips, beispielsweise eines Biochips, umfassend die Verfahrensschritte
a) Anordnen, insbesondere sandwichartiges Anordnen, einer thermoplastischen Elastomerfolie zwischen einem Basissubstrat und einem Decksubstrat,
   wobei zumindest eines der Substrate, das heißt das Basissubstrat und/oder das Decksubstrat, mindestens eine Vertiefung zum Ausbilden eines mikrofluidischen Raums mit einer auf der, der Elastomerfolie zugewandten Seite des Substrats ausgebildeten Vertiefungsöffnung aufweist,
b) Beaufschlagen der Anordnung mit einem Pressdruck derart, dass die Elastomerfolie zwischen dem Basissubstrat und dem Decksubstrat unter Verringerung der Dicke der Elastomerfolie komprimiert wird,
c) Ausbilden mindestens einer, die thermoplastische Elastomerfolie, das Basissubstrat und das Decksubstrat verbindenden Schweißstelle durch Laserschweißen, und
d) Entfernen des Pressdrucks.
Beim Entfernen des Pressdrucks in Verfahrensschritt d) hat die Elastomerfolie das Bestreben sich auszudehnen und wieder die ursprüngliche Dicke aus Verfahrensschritt a) einzunehmen. Durch die Schweißstelle werden jedoch das Basissubstrat und das Decksubstrat in einem Abstand zueinander fixiert, welcher im Wesentlichen der verringerten Foliendicke aus Verfahrensschritt b) entspricht, so dass sich die Elastomerfolie nicht auf ihre ursprüngliche Dicke ausdehnen kann. Durch diesen Effekt dient die Elastomerfolie als Dichtmittel, durch welches das Ausbilden von Kapillaren zwischen dem Basissubstrat und dem Decksubstrat vorteilhafterweise vermieden werden kann.

Im Sinn der vorliegenden Erfindung dienen die Begriffe "Basissubstrat" und "Decksubstrat" zur Unterscheidung der beiden Substrate sowie zur Beschreibung der Anordnung der Substrate zueinander, und legen nicht deren Ausrichtung bezüglich der Gravitationsrichtung fest.

Ein mikrofluidischer Raum kann beispielsweise eine Mikrokammer, zum Beispiel eine Reagenzienkammern, oder ein Mikrokanal, zum Beispiel ein Fluidkanal, sein. Erfindungsgemäß wird die Schweißstelle beabstandet zu der Vertiefungsöffnung ausgebildet. Auf diese Weise kann vorteilhafterweise eine Verformung der Wandung der Vertiefung und eine damit verbundenen Volumenänderung vermieden werden. Erfindungsgemäß steht der Abstand zwischen der Schweißstelle und der Vertiefungsöffnung zu der Dicke der Elastomerfolie im unkomprimierten Zustand in einem Verhältnis in einem Bereich von 2:1 bis 30:1, beispielsweise von 2:1 bis 10:1 Dies hat sich zur Vermeidung einer Kapillarausbildung als vorteilhaft erwiesen.

Zum Beispiel kann die Elastomerfolie kann im unkomprimierten Zustand eine Dicke in einem Bereich von ≥ 10 µm bis ≤ 300 µm, beispielsweise von ≥ 20 µm bis ≤ 100 µm, weiterhin beispielsweise von ≥ 20 µm bis ≤ 50 µm und/oder im komprimierten Zustand eine Dicke (dₖ) in einem Bereich von ≥ 2 µm bis ≤ 100 µm, beispielsweise von ≥ 10 µm bis ≤ 30 µm, und der Abstand zwischen der Schweißnaht und der die Vertiefungsöffnung einen Wert in einem Bereich von ≥ 10 µm bis ≤ 500 µm, beispielsweise von ≥ 50 µm bis ≤ 150 µm, aufweisen.

Im Rahmen einer weiteren, bevorzugten Ausführungsform des erfindungsgemäßen Verfahrens ist die Elastomerfolie um mindestens 20 Prozent, insbesondere mindestens 50 Prozent, beispielsweise um mindestens 70 Prozent, bezogen auf die Dicke der Elastomerfolie im unkomprimierten Zustand, komprimierbar. Dies hat sich ebenfalls zur Vermeidung einer Kapillarausbildung als vorteilhaft erwiesen.

Im Rahmen einer weiteren, bevorzugten Ausführungsform des erfindungsgemäßen Verfahrens weist der Pressdruck einen Wert in einem Bereich von ≥ 5 N/mm² bis ≤ 500 N/mm², beispielsweise von ≥ 10 N/mm² bis ≤ 100 N/mm² oder von ≥ 10 N/mm² bis ≤ 50 N/mm², auf.

Die Elastomerfolie, das Basissubstrat und das Decksubstrat sind vorzugsweise aus einem biokompatiblen Material ausgebildet. Dabei bedeutet biokompatibel, dass das Material möglichst wenige, insbesondere keine, Wechselwirkungen mit biochemischen Analyten und Proben eingeht. Das Basissubstrat und das Decksubstrat sind vorzugsweise aus einem Material ausgebildet, welches sich beim Ausüben des Pressdrucks nicht oder nicht wesentlich verformt.

Die Elastomerfolie kann beispielsweise mindestens ein thermoplastisches Elastomer, ausgewählt aus der Gruppe bestehend aus Polyolefin-Elastomeren (TPE-O), Polyurethan-Elastomeren (TPE-U), Polyester-Elastomeren (TPE-E), Copolyester-Elastomeren (TPC-ET), Styrol-Elastomeren (TPE-S), Polyamid-Elastomeren (TPE-A), Elastomer-Vulkanisaten (TPE-V), Kautschuk-Elastomeren oder Mischungen davon, umfassen beziehungsweise daraus ausgebildet sein. Insbesondere kann die Elastomerfolie ein thermoplastisches Elastomer, ausgewählt aus der Gruppe, bestehend aus Polyesterurethanen, Polyetherurethanen und Kautschuk-Bends, umfassen beziehungsweise daraus ausgebildet sein. Insbesondere kann es sich bei den Polyesterurethanen um Polyesterurethane handeln, welche Diphenylmethandiisocyanat (MDI), Hexamethylendiisocyanat (HDI), Dimethyldiphenylisocyanat (TODI) oder Mischungen davon und Polyadipatglykole, Polycaprolacetonglykole, Polyoxytetramethylenglykole, Polycarbonatdiolen oder Mischungen davon (als elastischen Anteil) umfassen. Bei den Polyetherurethanen kann es sich insbesondere um Polyetherurethane handeln, welche Diphenylmethandiisocyanat (MDI), Hexamethylendiisocyanat (HDI), Dimethyldiphenylisocyanat (TODI) oder Mischungen davon und Polyoxypropylendiole, Polyoxytetramethylendiole oder Mischungen davon, umfassen. Bei den Kautschuk Blends kann es sich insbesondere um Ethylen-Propylen-Copolymer-Polypropylen-Blends (EPM-PP), Ethylen-Propylendien-Polypropylen-Blends (EPDM-PP) oder Mischungen davon, handeln.

Das Basissubstrat und/oder das Decksubstrat können mindestens einen thermoplastischen Kunststoff umfassen beziehungsweise daraus ausgebildet sein. Beispielsweise können das Basissubstrat und/oder das Decksubstrat mindestens einen thermoplastischen Kunststoff, ausgewählt aus der Gruppe, bestehend aus Polyolefinen, insbesondere Polypropylen (PP), Polyethylen (PE) oder Polystyrol (PS), Polycarbonaten (PC), Poly(meth)acrylaten, insbesondere Polymethylmethacrylat (PMMA), Cyclo-Olefin-Copolymeren (COC) oder Cyclo-Olefin-Polymeren (COP) oder Mischungen davon, umfassen beziehungsweise daraus ausgebildet sein. Insbesondere können das Basissubstrat und/oder das Decksubstrat mindestens einen thermoplastischen Kunststoff, ausgewählt aus der Gruppe, bestehend aus Polycarbonaten, Polyolefinen (PP, PE), Cycloolefinpolymeren, Polystyrolen (PS), Polymethylmethacrylaten (PMMA) und Mischungen davon, umfassen beziehungsweise daraus ausgebildet sein.

Das Basissubstrat und/oder das Decksubstrat können beispielsweise durch ein Spritzguss- oder Heißprägeverfahren hergestellt werden. Die Vertiefung/en können dabei ebenfalls im Zuge des Spritzguss- oder Heißprägeverfahren hergestellt werden. Es ist jedoch ebenso möglich die Vertiefung/en durch ein additives Verfahren, beispielsweise durch Photolithographie aus einem Basissubstrat, auszubilden.

Das Basissubstrat und/oder das Decksubstrat können plattenförmig ausgebildet sein. Beispielsweise können das Basissubstrat und/oder das Decksubstrat eine Schichtdicke von ≥ 100 µm bis ≤ 5 mm, insbesondere von ≥ 300 µm bis ≤ 2 mm, zum Beispiel von ≥ 700 µm bis ≤ 1500 µm, aufweisen.

Die Vertiefungsöffnung beziehungsweise die Vertiefungsöffnungen können jeweils eine Fläche von kleiner oder gleich 500 mm² aufweisen. Beispielsweise kann eine Vertiefungsöffnung eine Fläche von ≥ 0,1 mm² bis ≤ 400 mm² aufweisen.

Grundsätzlich können die Elastomerfolie, das Basissubstrat und/oder das Decksubstrat laserabsorbierend sein. Dazu können die Elastomerfolie, das Basissubstrat und/oder das Decksubstrat einen schwarzen Farbstoff und/oder einen anderen Laserabsorber aufweisen. Als "andere Laserabsorber" sind beispielsweise Substanzen geeignet, die eine Wellenlänge beziehungsweise einen Wellenlängenbereich absorbieren, welche/r beim Laserschweißen verwendet wird. Derartige Substanzen sind beispielsweise "Lumogen" der Firma BASF und "Clearweld" der Firma Clearweld.

Zum Beispiel können
- das Basissubstrat und das Decksubstrat lasertransparent und die Elastomerfolie laserabsorbierend, oder
- die Elastomerfolie und das Basissubstrat lasertransparent und das Decksubstrat laserabsorbierend, oder
- die Elastomerfolie und das Decksubstrat lasertransparent und das Basissubstrat laserabsorbierend,
sein.

Die Elastomerfolie kann die Vertiefungsöffnung teilweise oder vollständig überspannen. Die Elastomerfolie kann die Vertiefungsöffnung jedoch auch nicht überspannen. Dies kann beispielsweise dadurch erzielt werden, dass die Elastomerfolie strukturiert wird oder ist. Beispielsweise kann die Elastomerfolie durch einen Durchbruch oder mehrerer Durchbrüche strukturiert sein.

Im Rahmen einer weiteren, bevorzugten Ausführungsform des erfindungsgemäßen Verfahrens weist die Elastomerfolie mindestens einen Durchbruch im Bereich der Vertiefungsöffnung auf. Dies hat den Vorteil, dass ein in der Vertiefung befindliches Material besser optisch beziehungsweise spektroskopisch untersucht werden kann, da das zu durchstrahlende Material der mikrofluidischen Vorrichtung und damit dessen Strahlungsabsorption reduziert wird.

Dabei kann die Form und Position des Durchbruchs der Elastomerfolie der Form und Position der Vertiefungsöffnung, insbesondere des Basissubstrats und/oder des Decksubstrats, entsprechen.

Im Rahmen einer weiteren, bevorzugten Ausführungsform des erfindungsgemäßen Verfahrens weist das Basissubstrat mindestens eine Vertiefung zum Ausbilden eines mikrofluidischen Raums mit einer auf der, der Elastomerfolie zugewandten Seite des Substrats ausgebildeten Vertiefungsöffnung auf, wobei das Decksubstrat gegenüberliegend zu der Vertiefungsöffnung des Basissubstrats keine Vertiefung aufweist. Dies hat den Vorteil, dass eine mikrofluidische Vorrichtung durch den Einsatz von einfach erhältlichen Bauteilen und unter geringem Verfahrensaufwand, beispielsweise aufgrund verminderter Justageanforderungen, hergestellt werden kann.

Im Rahmen einer weiteren, bevorzugten Ausführungsform des erfindungsgemäßen Verfahrens weisen das Basissubstrat und das Decksubstrat jeweils mindestens eine Vertiefung zum Ausbilden eines mikrofluidischen Raums mit einer auf der, der Elastomerfolie zugewandten Seite des Substrats ausgebildeten Vertiefungsöffnung auf. Insbesondere kann dabei die Vertiefungsöffnung des Basissubstrats gegenüberliegend zu der Vertiefungsöffnung des Decksubstrats ausgebildet sein. Darüber hinaus kann dabei insbesondere die Form und Position der Vertiefungsöffnung des Basissubstrats der Form und Position der Vertiefungsöffnung des Decksubstrats und/oder der Form und Position des Durchbruchs der Elastomerfolie entsprechen. Insofern die Elastomerfolie dabei keinen Durchbruch aufweist, kann die Anordnung vorteilhafterweise als Ventil oder als Pumpe eingesetzt werden. Insofern die Elastomerfolie einen Durchbruch aufweist, resultiert eine Verbindung zwischen zwei mikrofluidischen Räumen, beispielsweise von zwei in unterschiedlichen Ebenen liegenden Mikrokanälen, wobei ein in dem Gesamtraum befindliches Material besser optisch beziehungsweise spektroskopisch untersucht werden kann, da das zu durchstrahlende Material der mikrofluidischen Vorrichtung und damit dessen Strahlungsabsorption reduziert wird.
Die Schweißstelle kann insbesondere in Form einer Schweißnaht ausgebildet werden beziehungsweise sein. Zum Beispiel kann die Schweißstelle insbesondere in Form einer Schweißnaht ausgebildet werden beziehungsweise sein, welche die Vertiefungsöffnung, insbesondere des Basissubstrats und/oder des Decksubstrats, teilweise oder vollständig, insbesondere beabstandet, umläuft.

Ein weiterer Gegenstand der vorliegenden Erfindung ist eine mikrofluidische Vorrichtung, insbesondere ein mikrofluidischer Chip, beispielsweise ein Biochip, hergestellt durch ein erfindungsgemäßes Verfahren, welche eine thermoplastische Elastomerfolie, ein Basissubstrat und ein Decksubstrat, umfasst. Dabei weist zumindest eines der Substrate, das heißt das Basissubstrat und/oder das Decksubstrat, mindestens eine Vertiefung zum Ausbilden eines mikrofluidischen Raums mit einer auf der, der Elastomerfolie zugewandten Seite des Substrats ausgebildeten Vertiefungsöffnung auf. Die Elastomerfolie ist dabei, insbesondere sandwichartig, zwischen dem Basissubstrat und dem Decksubstrat angeordnet. Die thermoplastische Elastomerfolie, das Basissubstrat und das Decksubstrat sind dabei durch mindestens eine Schweißstelle, insbesondere Laserschweißstelle, miteinander verbunden.

Vorzugsweise weist die Elastomerfolie mindestens einen Durchbruch im Bereich der Vertiefungsöffnung auf. Dabei kann die Form und Position des Durchbruchs der Elastomerfolie der Form und Position der Vertiefungsöffnung, insbesondere des Basissubstrats und/oder des Decksubstrats, entsprechen.

Zum Beispiel kann das Basissubstrat mindestens eine Vertiefung zum Ausbilden eines mikrofluidischen Raums mit einer auf der, der Elastomerfolie zugewandten Seite des Substrats ausgebildeten Vertiefungsöffnung aufweisen, wobei das Decksubstrat gegenüberliegend zu der Vertiefungsöffnung des Basissubstrats keine Vertiefung aufweist.

Es ist jedoch ebenso möglich, dass sowohl das Basissubstrat als auch das Decksubstrat jeweils mindestens eine Vertiefung zum Ausbilden eines mikrofluidischen Raums mit einer auf der, der Elastomerfolie zugewandten Seite des Substrats ausgebildeten Vertiefungsöffnung aufweisen. Insbesondere kann dabei die Vertiefungsöffnung des Basissubstrats gegenüberliegend zu der Vertiefungsöffnung des Decksubstrats ausgebildet sein. Darüber hinaus kann dabei die Form und Position der Vertiefungsöffnung des Basissubstrats der Form und Position der Vertiefungsöffnung des Decksubstrats und/oder der Form und Position des Durchbruchs der Elastomerfolie entsprechen.

Hinsichtlich weiterer Merkmale und Vorteile dieser erfindungsgemäßen mikrofluidischen Vorrichtung wird hiermit explizit auf die im Zusammenhang mit dem erfindungsgemäßen Verfahren beschriebenen Merkmale und Vorteile verwiesen.

Darüber hinaus ist ein Gegenstand der vorliegenden Erfindung eine mikrofluidische Vorrichtung, insbesondere ein mikrofluidischer Chip, beispielsweise ein Biochip, zum Beispiel hergestellt durch ein erfindungsgemäßes Verfahren, umfassend eine thermoplastische Elastomerfolie, ein Basissubstrat und ein Decksubstrat. Dabei weist zumindest eines der Substrate, das heißt das Basissubstrat und/oder das Decksubstrat, mindestens eine Vertiefung zum Ausbilden eines mikrofluidischen Raums mit einer auf der, der Elastomerfolie zugewandten Seite des Substrats ausgebildeten Vertiefungsöffnung auf. Die Elastomerfolie ist dabei, insbesondere sandwichartig, zwischen dem Basissubstrat und dem Decksubstrat angeordnet. Die thermoplastische Elastomerfolie, das Basissubstrat und das Decksubstrat sind dabei durch mindestens eine Schweißstelle, insbesondere Laserschweißstelle, miteinander verbunden. Dabei weist die Elastomerfolie mindestens einen Durchbruch im Bereich der Vertiefungsöffnung auf. Dies hat den Vorteil, dass ein in der Vertiefung befindliches Material besser optisch beziehungsweise spektroskopisch untersucht werden kann, da das zu durchstrahlende Material der mikrofluidischen Vorrichtung und damit dessen Strahlungsabsorption reduziert wird.

Dabei kann die Form und Position des Durchbruchs der Elastomerfolie der Form und Position der Vertiefungsöffnung, insbesondere des Basissubstrats und/oder des Decksubstrats, entsprechen.

Zum Beispiel kann das Basissubstrat mindestens eine Vertiefung zum Ausbilden eines mikrofluidischen Raums mit einer auf der, der Elastomerfolie zugewandten Seite des Substrats ausgebildeten Vertiefungsöffnung aufweisen, wobei das Decksubstrat gegenüberliegend zu der Vertiefungsöffnung des Basissubstrats keine Vertiefung aufweist.

Es ist jedoch ebenso möglich, dass sowohl das Basissubstrat als auch das Decksubstrat jeweils mindestens eine Vertiefung zum Ausbilden eines mikrofluidischen Raums mit einer auf der, der Elastomerfolie zugewandten Seite des Substrats ausgebildeten Vertiefungsöffnung aufweisen. Insbesondere kann dabei die Vertiefungsöffnung des Basissubstrats gegenüberliegend zu der Vertiefungsöffnung des Decksubstrats ausgebildet sein. Darüber hinaus kann dabei die Form und Position der Vertiefungsöffnung des Basissubstrats der Form und Position der Vertiefungsöffnung des Decksubstrats und/oder der Form und Position des Durchbruchs der Elastomerfolie entsprechen.

Hinsichtlich weiterer Merkmale und Vorteile dieser erfindungsgemäßen mikrofluidischen Vorrichtung wird hiermit explizit auf die im Zusammenhang mit dem erfindungsgemäßen Verfahren beschriebenen Merkmale und Vorteile verwiesen.

Ferner ist ein Gegenstand der vorliegenden Erfindung eine mikrofluidische Vorrichtung, insbesondere ein mikrofluidischer Chip, beispielsweise ein Biochip, zum Beispiel hergestellt durch ein erfindungsgemäßes Verfahren, welche eine thermoplastische Elastomerfolie, ein Basissubstrat und ein Decksubstrat umfasst. Dabei weist das Basissubstrat mindestens eine Vertiefung zum Ausbilden eines mikrofluidischen Raums mit einer auf der, der Elastomerfolie zugewandten Seite des Substrats ausgebildeten Vertiefungsöffnung auf. Dabei weist das Decksubstrat gegenüberliegend zu der Vertiefungsöffnung des Basissubstrats keine Vertiefung auf. Die Elastomerfolie ist dabei, insbesondere sandwichartig, zwischen dem Basissubstrat und dem Decksubstrat angeordnet. Die thermoplastische Elastomerfolie, das Basissubstrat und das Decksubstrat sind dabei durch mindestens eine Schweißstelle, insbesondere Laserschweißstelle, miteinander verbunden. Dies hat den Vorteil, dass eine mikrofluidische Vorrichtung durch den Einsatz von einfach erhältlichen Bauteilen und unter geringem Verfahrensaufwand, beispielsweise aufgrund verminderter Justageanforderungen, hergestellt werden kann.

Vorzugsweise weist die Elastomerfolie mindestens einen Durchbruch im Bereich der Vertiefungsöffnung auf. Dabei kann die Form und Position des Durchbruchs der Elastomerfolie der Form und Position der Vertiefungsöffnung des Basissubstrats entsprechen.

Hinsichtlich weiterer Merkmale und Vorteile dieser erfindungsgemäßen mikrofluidischen Vorrichtung wird hiermit explizit auf die im Zusammenhang mit dem erfindungsgemäßen Verfahren beschriebenen Merkmale und Vorteile verwiesen.

### Zeichnungen

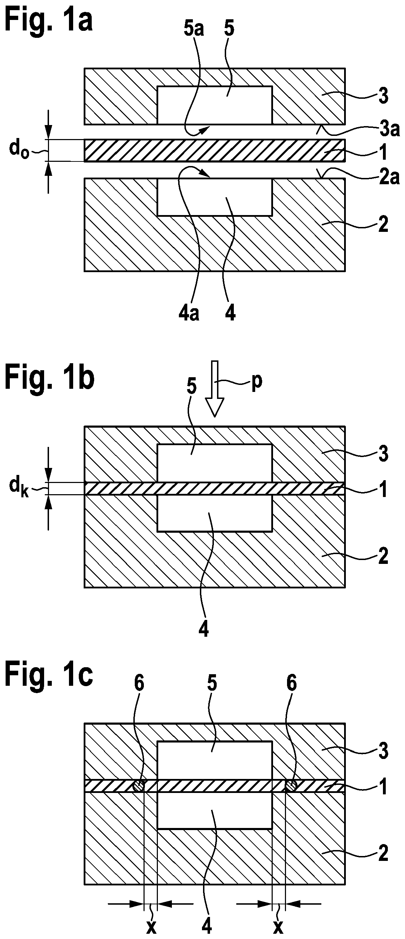

Weitere Vorteile und vorteilhafte Ausgestaltungen der erfindungsgemäßen Gegenstände werden durch die Zeichnungen veranschaulicht und in der nachfolgenden Beschreibung erläutert. Dabei ist zu beachten, dass die Zeichnungen nur beschreibenden Charakter haben und nicht dazu gedacht sind, die Erfindung in irgendeiner Form einzuschränken. Es zeigen
- Fig. 1a: einen schematischen Querschnitt zur Veranschaulichung des Verfahrensschrittes a);

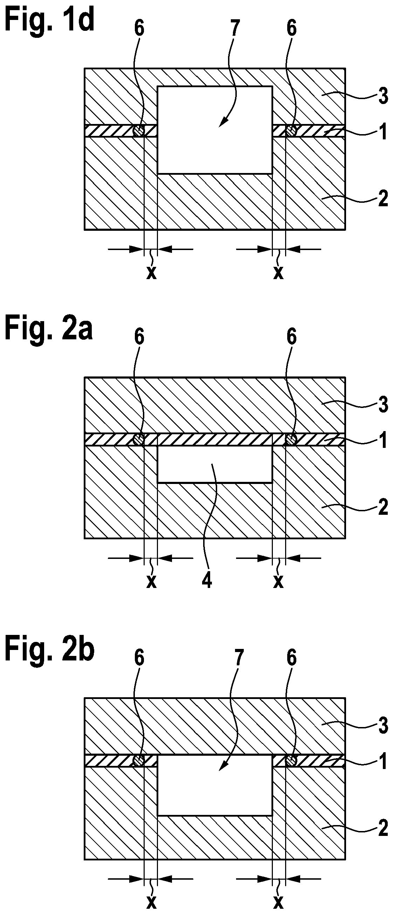

- Fig. 1 b: einen schematischen Querschnitt zur Veranschaulichung des Verfahrensschrittes b);
- Fig. 1 c: einen schematischen Querschnitt zur Veranschaulichung der Verfahrensschritte c) und d) sowie einer ersten Ausführungsform einer erfindungsgemäßen mikrofluidischen Vorrichtung;
- Fig. 1 d: einen schematischen Querschnitt zur Veranschaulichung einer zweiten Ausführungsform einer erfindungsgemäßen mikrofluidischen Vorrichtung;
- Fig. 2a: einen schematischen Querschnitt zur Veranschaulichung einer dritten Ausführungsform einer erfindungsgemäßen mikrofluidischen Vorrichtung; und
- Fig. 2b: einen schematischen Querschnitt zur Veranschaulichung einer vierten Ausführungsform einer erfindungsgemäßen mikrofluidischen Vorrichtung.

Figur 1 a zeigt, dass im Rahmen von Verfahrensschritt a) eine thermoplastische Elastomerfolie 1 zwischen einem Basissubstrat 2 und einem Decksubstrat 3 sandwichartig angeordnet wird. Figur 1 a zeigt, dass dabei das Basissubstrat 2 und das Decksubstrat 3 jeweils eine Vertiefung 4,5 zum Ausbilden eines mikrofluidischen Raums mit einer auf der, der Elastomerfolie 1 zugewandten Seite 2a,3a des Substrats 2,3 ausgebildeten Vertiefungsöffnung 4a,5a aufweisen. Weiterhin zeigt Figur 1a, dass die Vertiefungsöffnung 4a des Basissubstrats 2 gegenüberliegend zu der Vertiefungsöffnung 5a des Decksubstrats 5 ausgebildet ist, wobei die Form und Position der Vertiefungsöffnung 4a des Basissubstrats 2, der Form und Position der Vertiefungsöffnung 5a des Decksubstrats 3 entspricht. Im Rahmen der vorliegenden Erfindung ist es jedoch ebenso möglich, dass die Form und Position der Vertiefungsöffnung 4a des Basissubstrats 2 unterschiedlich zur Form und Position der Vertiefungsöffnung 5a des Decksubstrats 3 beziehungsweise zur Form und Position eines Durchbruchs 7 durch die Elastomerfolie 1 ist. Darüber hinaus veranschaulicht Figur 1a, dass die Elastomerfolie im unkomprimierten Zustand eine Dicke dₒ aufweist.

Figur 1b veranschaulicht, dass im Rahmen von Verfahrensschritt b) die in Figur 1 a gezeigte Anordnung aus Verfahrensschritt a) derart mit einem Pressdruck p beaufschlagt wird, dass die Elastomerfolie 1 zwischen dem Basissubstrat 2 und dem Decksubstrat 3 komprimiert wird, wobei sich die Dicke der Elastomerfolie von der Dicke dₒ im unkomprimierten Zustand aus Verfahrensschritt a) zur Dicke dₖ im komprimierten Zustand in Verfahrensschritt b) verringert. Figur 1b illustriert weiterhin, dass die Vertiefungen 4,5 aus Verfahrensschritt a) zusammen mit der Elastomerfolie 1 nun jeweils einen mikrofluidischen Raum ausbilden.

Figur 1c zeigt, dass im Rahmen von Verfahrensschritt b) durch Laserschweißen zwei Schweißstellen, insbesondere Schweißnähte, ausgebildet wurden, welche die thermoplastische Elastomerfolie 1, das Basissubstrat 2 und das Decksubstrat 3 verbinden. Figur 1c illustriert, dass die Schweißstelle 6 beabstandet um den Abstand x zu der Vertiefungsöffnung 4a,5a ausgebildet wurden. Figur 1c veranschaulicht weiterhin, dass nach dem anschließenden Entfernen des Pressdrucks p in Verfahrensschritt d) durch die Schweißstelle 6 das Basissubstrat und das Decksubstrat in einem Abstand zueinander fixiert werden, welcher im Wesentlichen der verringerten Foliendicke dₖ aus Verfahrensschritt b) entspricht, so dass sich Elastomerfolie 1 nicht auf ihre ursprüngliche Dicke dₒ im unkomprimierten Zustand aus Verfahrensschritt a) ausdehnen kann, was zur Folge hat, dass die Elastomerfolie 1 als Dichtmittel dient und das Ausbilden von Kapillaren zwischen dem Basissubstrat 2 und dem Decksubstrat 3 vorteilhafterweise vermieden wird. Eine derartige mikrofluidische Vorrichtung ist vorteilhafterweise als Ventil oder Pumpe einsetzbar.

Figur 1d zeigt eine zweite Ausführungsform einer erfindungsgemäßen mikrofluidischen Vorrichtung, welche sich von der ersten, in Figur 1c gezeigten Ausführungsform im Wesentlichen dadurch unterscheidet, dass die Elastomerfolie 1 einen Durchbruch 7 im Bereich der Vertiefungsöffnung 4 aufweist, wobei die Form und Position des Durchbruchs 7 der Elastomerfolie 1, der Form und Position der Vertiefungsöffnung 4a des Basissubstrats 2 und/oder der Form und Position der Vertiefungsöffnung 5b des Decksubstrats 3 entspricht. Eine derartige mikrofluidische Vorrichtung ist besonders vorteilhaft zur optischen oder spektroskopischen Analyse von darin befindlichen Substanzen.

Figur 2a zeigt eine dritte Ausführungsform einer erfindungsgemäßen mikrofluidischen Vorrichtung, welche sich von der ersten, in Figur 1c gezeigten Ausführungsform im Wesentlichen dadurch unterscheidet, dass das Basissubstrat 2 zwar eine Vertiefung 4 zum Ausbilden eines mikrofluidischen Raums mit einer auf der, der Elastomerfolie 1 zugewandten Seite 2a des Substrats 2 ausgebildeten Vertiefungsöffnung 4a aufweist, das Decksubstrat 3 gegenüberliegend zu der Vertiefungsöffnung 4 des Basissubstrats 2 jedoch keine Vertiefung aufweist. Eine derartige mikrofluidische Vorrichtung ist vorteilhafterweise mit einfachen und günstigen Mitteln herzustellen.

Figur 2b zeigt eine vierte Ausführungsform einer erfindungsgemäßen mikrofluidischen Vorrichtung, welche sich von der dritten, in Figur 2a gezeigten Ausführungsform im Wesentlichen dadurch unterscheidet, dass die Elastomerfolie 1 einen Durchbruch 7 im Bereich der Vertiefungsöffnung 4 aufweist, wobei die Form und Position des Durchbruchs 7 der Elastomerfolie 1, der Form und Position der Vertiefungsöffnung 4a des Basissubstrats 2 und der Form und Position der Vertiefungsöffnung 5b des Decksubstrats 3 entspricht. Eine derartige mikrofluidische Vorrichtung vereint die Vorteile der einfachen und kostengünstigen Herstellung mit den Vorteilen einer verbesserten optischen oder spektroskopischen Analysefähigkeit.

## Patentansprüche

1. Verfahren zur Herstellung einer mikrofluidischen Vorrichtung, umfassend die Verfahrensschritte
a) Anordnen einer thermoplastischen Elastomerfolie (1) zwischen einem Basissubstrat (2) und einem Decksubstrat (3), wobei zumindest eines der Substrate (2,3) mindestens eine Vertiefung (4,5) zum Ausbilden eines mikrofluidischen Raums mit einer auf der, der Elastomerfolie (1) zugewandten Seite (2a,3a) des Substrats (2,3) ausgebildeten Vertiefungsöffnung (4a,5a) aufweist,
b) Beaufschlagen der Anordnung mit einem Pressdruck (p) derart, dass die Elastomerfolie (1) zwischen dem Basissubstrat (2) und dem Decksubstrat (3) unter Verringerung der Dicke (dₒ,dₖ) der Elastomerfolie (1) komprimiert wird,
c) Ausbilden mindestens einer, die thermoplastische Elastomerfolie (1), das Basissubstrat (2) und das Decksubstrat (3) verbindenden Schweißstelle (6) durch Laserschweißen, wobei die Schweißstelle (6) beabstandet zu der Vertiefungsöffnung (4a,5a) ausgebildet wird, wobei ein Abstand (x) zwischen der Schweißstelle (6) und der Vertiefungsöffnung (4a,5a) zu der Dicke (dₒ) der Elastomerfolie (1) im unkomprimierten Zustand in einem Verhältnis in einem Bereich von 2:1 bis 30:1 steht und
d) Entfernen des Pressdrucks (p).

2. Verfahren nach Anspruch 1, **dadurch gekennzeichnet, dass** die Elastomerfolie (1) um mindestens 20 Prozent, bezogen auf die Dicke (dₒ) der Elastomerfolie im unkomprimierten Zustand, komprimierbar ist.

3. Verfahren nach einem der Ansprüche 1 bis 2 **dadurch gekennzeichnet, dass** der Pressdruck (p) einen Wert in einem Bereich von ≥ 5 N/mm² bis ≤ 500 N/mm aufweist.

4. Verfahren nach einem der Ansprüche 1 bis 3, **dadurch gekennzeichnet, dass** die Elastomerfolie (1) mindestens einen Durchbruch (7) im Bereich der Vertiefungsöffnung (4,5) aufweist.

5. Verfahren nach einem der Ansprüche 1 bis 4, **dadurch gekennzeichnet, dass** das Basissubstrat (2) mindestens eine Vertiefung (4) zum Ausbilden eines mikrofluidischen Raums mit einer auf der, der Elastomerfolie (1) zugewandten Seite (2a) des Substrats (2) ausgebildeten Vertiefungsöffnung (4a) aufweist, und
das Decksubstrat (3) gegenüberliegend zu der Vertiefungsöffnung (4) des Basissubstrats (3) keine Vertiefung (4) aufweist.

6. Verfahren nach einem der Ansprüche 1 bis 4, **dadurch gekennzeichnet, dass** das Basissubstrat (2) und das Decksubstrat (3) jeweils mindestens eine Vertiefung (4,5) zum Ausbilden eines mikrofluidischen Raums mit einer auf der, der Elastomerfolie (1) zugewandten Seite (2a,3a) des Substrats (2,3) ausgebildeten Vertiefungsöffnung (4a,5a) aufweist,
wobei die Vertiefungsöffnung (4) des Basissubstrats (2) gegenüberliegend zu der Vertiefungsöffnung (5) des Decksubstrats (3) ausgebildet ist,
wobei die Form und Position der Vertiefungsöffnung (4) des Basissubstrats (2) der Form und Position der Vertiefungsöffnung (5) des Decksubstrats (3) und/oder der Form und Position des Durchbruchs (7) der Elastomerfolie (1) entspricht.

7. Mikrofluidische Vorrichtung, herstellbar durch ein Verfahren nach einem der Ansprüche 1 bis 8, umfassend
- eine thermoplastische Elastomerfolie (1),
- ein Basissubstrat (2), und
- ein Decksubstrat (3),
wobei zumindest eines der Substrate (2,3) mindestens eine Vertiefung (4,5) zum Ausbilden eines mikrofluidischen Raums mit einer auf der, der Elastomerfolie (1) zugewandten Seite (2a) des Substrats (2) ausgebildeten Vertiefungsöffnung (4a) aufweist,
wobei die Elastomerfolie (1) zwischen dem Basissubstrat (2) und dem Decksubstrat (3) angeordnet ist,
wobei die thermoplastische Elastomerfolie (1), das Basissubstrat (2) und das Decksubstrat (3) durch mindestens eine Schweißstelle (6) miteinander verbunden sind, **dadurch gekennzeichnet, dass** die Schweißstelle (6) beabstandet zu der Vertiefungsöffnung (4a) ausgebildet ist und dass ein Abstand (x) zwischen der Schweißstelle (6) und der Vertiefungsöffnung (4a,5a) zu der Dicke (dₒ) der Elastomerfolie (1) im unkomprimierten Zustand in einem Verhältnis in einem Bereich von 2:1 bis 30:1 steht.

8. Mikrofluidische Vorrichtung nach Anspruch 7, **dadurch gekennzeichnet, dass** die Elastomerfolie (1) mindestens einen Durchbruch (7) im Bereich der Vertiefungsöffnung (4) aufweist.

9. Mikrofluidische Vorrichtung nach Anspruch 7, **dadurch gekennzeichnet, dass** das Basissubstrat (2) mindestens eine Vertiefung (4) zum Ausbilden eines mikrofluidischen Raums mit einer auf der, der Elastomerfolie (1) zugewandten Seite (2a) des Substrats (2) ausgebildeten Vertiefungsöffnung (4a) aufweist,
wobei das Decksubstrat (3) gegenüberliegend zu der Vertiefungsöffnung (4) des Basissubstrats (2) keine Vertiefung aufweist.

## Claims

1. Method for producing a microfluidic device, comprising the method steps of
a) arranging a thermoplastic elastomer film (1) between a base substrate (2) and a cover substrate (3),
at least one of the substrates (2, 3) having at least one depression (4, 5) for forming a microfluidic chamber, with a depression opening (4a, 5a) formed on the side (2a, 3a) of the substrate (2, 3) that is facing the elastomer film (1),
b) subjecting the arrangement to a pressing pressure (p) in such a way that the elastomer film (1) is compressed between the base substrate (2) and the cover substrate (3), while thereby reducing the thickness (dₒ, dₖ) of the elastomer film (1),
c) forming by laser welding at least one weld (6) connecting the thermoplastic elastomer film (1), the base substrate (2) and the cover substrate (3), wherein the weld (6) is formed at a distance from the depression opening (4a, 5a), wherein a distance (x) between the weld (6) and the depression opening (4a, 5a) is in a ratio to the thickness (dₒ) of the elastomer film (1) in the uncompressed state in a range from 2:1 to 30:1, and
d) removing the pressing pressure (p).

2. Method according to Claim 1, **characterized in that** the elastomer film (1) can be compressed by at least 20 percent, with respect to the thickness (dₒ) of the elastomer film in the uncompressed state.

3. Method according to either of Claims 1 and 2, **characterized in that** the pressing pressure (p) has a value in a range from ≥ 5 N/mm² to ≤ 500 N/mm².

4. Method according to one of Claims 1 to 3, **characterized in that** the elastomer film (1) has at least one aperture (7) in the region of the depression opening (4, 5).

5. Method according to one of Claims 1 to 4, **characterized in that** the base substrate (2) has at least one depression (4) for forming a microfluidic chamber, with a depression opening (4a) formed on
the side (2a) of the substrate (2) that is facing
the elastomer film (1), and
the cover substrate (3) not having a depression (4) opposite the depression opening (4) of the base substrate (3).

6. Method according to one of Claims 1 to 4, **characterized in that** the base substrate (2) and
the cover substrate (3) respectively have at least one depression (4, 5) for forming a microfluidic chamber, with a depression opening (4a, 5a) formed on the side (2a, 3a) of the substrate (2, 3) that is facing the elastomer film (1),
the depression opening (4) of the base substrate (2) being formed opposite the depression opening (5) of the cover substrate (3),
the form and position of the depression opening (4) of the base substrate (2) corresponding to the form and position of the depression opening (5) of the cover substrate (3) and/or the form and position of the aperture (7) of the elastomer film (1).

7. Microfluidic device, which can be produced by a method according to one of Claims 1 to 8, comprising
- a thermoplastic elastomer film (1),
- a base substrate (2), and
- a cover substrate (3),
at least one of the substrates (2, 3) having at least one depression (4, 5) for forming a microfluidic chamber, with a depression opening (4a) formed on the side (2a) of the substrate (2) that is facing the elastomer film (1),
the elastomer film (1) being arranged between the base substrate (2) and the cover substrate (3),
the thermoplastic elastomer film (1), the base substrate (2) and the cover substrate (3) being connected to one another by at least one weld (6), **characterized in that** the weld (6) is formed at a distance from the depression opening (4a) and **in that** a distance (x) between the weld (6) and the depression opening (4a, 5a) is in a ratio to the thickness (dₒ) of the elastomer film (1) in the uncompressed state in a range from 2:1 to 30:1.

8. Microfluidic device according to Claim 7, **characterized in that**
the elastomer film (1) has at least one aperture (7) in the region of the depression opening (4).

9. Microfluidic device according to Claim 7, **characterized in that**
the base substrate (2) has at least one depression (4) for forming a microfluidic chamber, with a depression opening (4a) formed on the side (2a) of the substrate (2) that is facing the elastomer film (1),
the cover substrate (3) not having a depression opposite the depression opening (4) of the base substrate (2).

## Revendications

1. Procédé pour la réalisation d'un dispositif microfluidique, comprenant les étapes suivantes:
a) agencer une feuille élastomère thermoplastique (1) entre un substrat de base (2) et un substrat de couverture (3),
dans lequel au moins un des substrats (2, 3) présente au moins un creux (4, 5) pour former une chambre microfluidique avec une ouverture de creux (4a, 5a) formée sur le côté (2a, 3a) du substrat (2, 3) tourné vers la feuille élastomère (1),
b) exposer l'agencement à une pression de pressage (p), de telle manière que la feuille élastomère (1) soit comprimée entre le substrat de base (2) et le substrat de couverture (3) avec diminution de l'épaisseur (dₒ, dₖ) de la feuille élastomère (1),
c) former au moins un point de soudure (6) assemblant la feuille élastomère thermoplastique (1), le substrat de base (2) et le substrat de couverture (3) par soudage au laser, dans lequel le point de soudure (6) est formé à distance de l'ouverture de creux (4a, 5a), dans lequel une distance (x) entre le point de soudure (6) et l'ouverture de creux (4a, 5a) se trouve dans un rapport de 2:1 à 30:1 avec l'épaisseur (dₒ) de la feuille élastomère (1) à l'état non comprimé, et
d) supprimer la pression de pressage (p).

2. Procédé selon la revendication 1, **caractérisé en ce que** la feuille élastomère (1) peut être comprimée d'au moins 20 pour cent, rapportés à l'épaisseur (dₒ) de la feuille élastomère (1) à l'état non comprimé.

3. Procédé selon une des revendications 1 à 2, **caractérisé en ce que** la pression de pressage (p) présente une valeur comprise dans une plage de ≥ 5 N/mm² à ≤ 500 N/mm².

4. Procédé selon l'une quelconque des revendications 1 à 3, **caractérisé en ce que** la feuille élastomère (1) présente au moins une percée (7) dans la région de l'ouverture de creux (4, 5).

5. Procédé selon l'une quelconque des revendications 1 à 4, **caractérisé en ce que** le substrat de base (2) présente au moins un creux (4) pour former une chambre microfluidique avec une ouverture de creux (4a) formée sur le côté (2a) du substrat (2) tourné vers la feuille élastomère (1), et le substrat de couverture (3) ne présente pas de creux (4) en face de l'ouverture de creux (4) du substrat de base (3).

6. Procédé selon l'une quelconque des revendications 1 à 4, **caractérisé en ce que** le substrat de base (2) et le substrat de couverture (3) présentent respectivement au moins un creux (4, 5) pour former une chambre microfluidique avec une ouverture de creux (4a, 5a) formée sur le côté (2a, 3a) du substrat (2, 3) tourné vers la feuille élastomère (1);
dans lequel l'ouverture de creux (4) du substrat de base (2) est formée en face de l'ouverture de creux (5) du substrat de couverture (3),
dans lequel la forme et la position de l'ouverture de creux (4) du substrat de base (2) correspondent à la forme et à la position de l'ouverture de creux (5) du substrat de couverture (3) et/ou à la forme et à la position de la percée (7) de la feuille élastomère (1).

7. Dispositif microfluidique pouvant être réalisé par un procédé selon l'une quelconque des revendications 1 à 8, comprenant:
- une feuille élastomère thermoplastique (1),
- un substrat de base (2), et
- un substrat de couverture (3),
dans lequel au moins un des substrats (2, 3) présente au moins un creux (4, 5) pour former une chambre microfluidique avec une ouverture de creux (4a) formée sur le côté (2a) du substrat (2) tourné vers la feuille élastomère (1),
dans lequel la feuille élastomère (1) est agencée entre le substrat de base (2) et le substrat de couverture (3),
dans lequel la feuille élastomère thermoplastique (1), le substrat de base (2) et le substrat de couverture (3) sont assemblés l'un à l'autre par au moins un point de soudure (6),
**caractérisé en ce que** le point de soudure (6) est formé à distance de l'ouverture de creux (4a) et **en ce qu'**une distance (x) entre le point de soudure (6) et l'ouverture de creux (4a, 5a) se trouve dans un rapport de 2:1 à 30:1 avec l'épaisseur (dₒ) de la feuille élastomère (1) à l'état non comprimé.

8. Dispositif microfluidique selon la revendication 7, **caractérisé en ce que** la feuille élastomère (1) présente au moins une percée (7) dans la région de l'ouverture de creux (4).

9. Dispositif microfluidique selon la revendication 7, **caractérisé en ce que** le substrat de base (2) présente au moins un creux (4) pour former une chambre microfluidique avec une ouverture de creux (4a) formée sur le côté (2a) du substrat (2) tourné vers la feuille élastomère (1), dans lequel le substrat de couverture (3) ne présente pas de creux en face de l'ouverture de creux (4) du substrat de base (2).
